(19) Europäisches Patentamt
European Patent Office
Office européen des brevets

(11) **EP 4 478 060 B1**

(12) **EUROPEAN PATENT SPECIFICATION**

(45) Date of publication and mention
of the grant of the patent:
**23.07.2025  Bulletin 2025/30**

(21) Application number: **24175565.1**

(22) Date of filing: **13.05.2024**

(51) International Patent Classification (IPC):
*G01R 23/02* *(2006.01)*

(52) Cooperative Patent Classification (CPC):
**G01R 23/02**

(54) **METHOD AND SYSTEM FOR MEASURING THE FREQUENCY OF A WAVEFORM AND/OR ITS DERIVATIVE**

VERFAHREN UND SYSTEM ZUR MESSUNG DER FREQUENZ EINER WELLENFORM UND/ODER IHRER ABLEITUNG

MÉTHODE ET SYSTÈME DE MESURE DE LA FRÉQUENCE D'UNE FORME D'ONDE ET/OU DE SA DÉRIVÉE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **18.05.2023  ES 202330386**

(43) Date of publication of application:
**18.12.2024  Bulletin 2024/51**

(73) Proprietor: **Romero Gordon, José María**
**41908 Castilleja de Guzmán Sevilla (ES)**

(72) Inventor: **Romero Gordon, José María**
**41908 Castilleja de Guzmán Sevilla (ES)**

(56) References cited:
**CN-A- 108 918 961        US-A- 5 019 722**
**US-A1- 2013 341 922     US-A1- 2017 040 900**
**US-A1- 2018 059 154**

**Description**

**Technical Field**

The present technology belongs to signal processing methods. It relates in particular to techniques for measuring the frequency of an analogue or digital signal and parameters related to frequency and its derivative.

**Background Art**

In various fields of technology and industry, an accurate and fast measurement of the frequency of a signal is required. To name but a few, it is necessary for the control of equipment connected to a power grid operator, and also for the stability of the power grid itself as a whole. Generators and loads must adjust its consumption or generation pattern according to the value of the frequency or its derivative measured at its connection point. Likewise, the measurement of the frequency at various geographical locations provides the entity in charge of the control and regulation of the electricity grid with elements of judgement with which to make decisions. For example, to order the connection or disconnection of generation groups in real time, preventing the grid from becoming unstable or collapsing. Certain electrical protection relays depend on frequency measurements, as they are responsible for disconnecting circuits when the frequency exceeds certain limits.

Currently, accurate frequency measurement is usually done with very complex equipment and permanent GPS (Global Positioning System) synchronisation, which prevents its mass use in embedded equipment. These techniques do not provide sufficient immunity to signal disturbances (e.g. harmonics), nor to low-frequency modulations of the signal amplitude and phase. Moreover, the measurement of the frequency derivative of the grid, which is, in many applications, a key variable in providing stability to the power grid, is particularly poor. The frequency derivative is a reflection of the time lag between instantaneous power generation and demand. If a frequency measurement with low latency (defined as the time between the occurrence of a change in the network and the time it takes to identify it) is required, the accuracy is substantially reduced. If, on the other hand, a precise measurement is required, then filtering is introduced which results in a delay in the output of the equipment that is a source of instability in a control circuit.

Currently, there is no uniform approach to the frequency measurement method, and there is a significant gap between the measurement performed by protection relays, equipment specifically dedicated to frequency measurement (e.g. PMU -Phasor Measurement Unit-) and power quality equipment (Power Quality Meter).

**Summary of Invention**

Considering the limitations identified in the prior art, a process and a system for measuring the frequency of a waveform and/or its derivative corresponding to an input signal according to the independent claims is presented. Particularly advantageous embodiments are defined in the dependent claims.

**Technical Problem**

Mathematically, if a signal is periodic, its frequency is constant (and its derivative null). In this paper, a less strict definition is used. Generally, a signal is said to be periodic because it repeats in cycles. The length of the cycles may vary, which means that the actual frequency value varies from its nominal value. The procedure and system is primarily applicable to input signals, both analogue and digital, which are cyclic, i.e., which are quasi-periodic in the mathematical sense.

Existing inventions that could be more closely related to the invention to be patented will be discussed below. For obvious reasons, technologies based on completely different mathematical concepts, such as synchrophasors or Clark or Park transforms, are not analysed.

In all the inventions reviewed, clocks with a fixed sampling frequency are used.

A number of patents focus on frequency measurement by measuring the time between two zero crossings of the signal and calculating its inverse value, in some cases applying filtering, interpolation or integration around the crossings to estimate the intersection more accurately (CN103575979A, CN102095929A, CN101871965A, CN102879639A, CN1815248A, CN102116798A, CN104360144A, CN109669070A, CN105259409A); in these inventions the frequency is estimated by taking several network cycles and calculating their average period value.

Other patents improve the estimation by applying a typical hysteresis comparator instead of a zero-crossing comparator, usually with a pair of thresholds, one positive and one negative which is its opposite (GB2528847A, JPH0943262A, CN109669070A, GB1338980A, US7184937B1). By this change, instead of measuring the period of the periodic signal, the period of the output of the hysteresis comparator is measured, which is much more immune to noise (a particular case is patent US4480200A, which limits itself to creating the square hysteresis comparator signal, but without estimating the frequency). In addition, some of the patents analysed improve the measurement of the periods by applying filtering prior to the hysteresis comparator (GB2528847A), or a more complex process of attenuation, rectification of the signal and setting a positive threshold around which the hysteresis levels are defined, also positive (US2017040900A1); however, these filters inevitably add phase shifts and therefore delays in the calculation of the frequency.

More elaborate methods are also employed, such as in CN114217126A, where in four consecutive zero-crossings the input signal is adjusted to a hypothetical ideal signal whose frequency is defined as a function *f(t)* approximated by a Taylor series, and the frequency can be evaluated at any nearby instant t using precisely that function *f(t)*. Or as in US11204377B2, where the minimum of the convolution of the signal with itself is sought, in order to obtain the optimum value of the period and, therefore, of the frequency; furthermore, based on the stability of the calculated periods, it determines the quality of the measurement.

The main problem with most of the above inventions is that, in order to increase the number of period samples and gain accuracy, they must rely on a measurement interval of several or many cycles, so that if they do so they are not able to capture the dynamic frequency sense of the input signal, and if they do not they simply give a very poor measurement, with poor accuracy. Some of them attempt to correct for this by filtering and interpolating values, but the former inevitably adds delay, while the latter is very sensitive to noise and harmonics. In addition, the measurement of the frequency derivative is usually based on the approximation by the ratio of the increment and the time, thus using only one pair of values and the uncertainty of the resulting measurement can be very large; in this case the most direct possibility to increase the accuracy is to increase the denominator of the ratio, which adds delay, while still using only one pair of values for the calculation. Patent CN114217126A, by obtaining a Taylor series of the frequency function *f(t)*, is able to automatically evaluate its derivative algebraically, although the origin of the fit to that function still falls on a few points, so the accuracy is not expected to be good in real conditions either.

**Solution to Problem**

To measure the frequency of an input (analogue) signal, several steps are performed:

- digitisation of the input signal and obtaining a waveform for digital processing, where the waveform is understood as a stream of data corresponding to the digitised input signal;

- optionally, normalising the waveform and obtaining a normalised waveform of amplitude equal to or close to one;

- comparison, in each calculation period, of the original or optionally the normalised waveform with a plurality of levels whose value, whether selectable or preset, is within the full scale of the measurement, so that crossovers between them and the waveform can be made;

- generating a plurality of measurement functions associated with these levels, where each measurement function has a rising edge at a first level and a falling edge at a second level, which change according to the coincidence of the waveform with its level and the fulfilment of a hysteresis condition;

- recording multiple values for each measurement function, where each value corresponds temporally to a cycle, i.e., a time interval between two consecutive rising or falling edges;

- application of a statistical calculation to estimate the frequency of the waveform and associate it with the frequency of the input signal from the periods of the plurarity of the measurement functions.

The hysteresis condition is introduced to avoid bouncing, i.e. oscillations of the waveform around the level that serves to define the measurement function. A hysteresis condition defines two situations:

That, from the first, higher level, it goes to a falling edge towards the second, lower level, when the waveform goes below the second selected level.

That, from the second level, it goes to rising edge towards the first level when the waveform rises above the selected level.

Well known and obvious methods based on the approximation of the derivative by its increments can be used to measure the derivative of the frequency (also named ROCOF or *"Rate of Change of Frequency"*). However, a much more accurate method is also proposed where the following steps are performed on an (analogue) input signal:

- digitisation of the input signal and obtaining a waveform for digital processing, where the waveform is understood as a stream of data corresponding to the digitised input signal;

- optionally, normalising the waveform and obtaining a normalised waveform of amplitude equal to or close to one;

- comparison, in each calculation period, of the original or optionally the normalised waveform with a plurality of levels whose value, whether selectable or preset, is within the full scale of the measurement, so that crossovers between them and the waveform can be made;

- generation of a plurality of measurement functions associated with these levels, where each measurement function has a rising edge at a first level and a falling edge at a second level, which change according to the coincidence of the waveform with its level and the fulfilment of a hysteresis condition;

- recording multiple pairs of values for each measurement function, where each pair corresponds temporally to a cycle, its first element being the average timestamp of the cycle, and the second element being its duration; the average timestamp is calculated as the arithmetic mean of the timestamps between two consecutive rising or falling edges, while the duration is calculated as the absolute value of their difference;

- application of a linear approximation statistical calculation to estimate the frequency derivative of the waveform from the estimated slope of the set of pairs of values of the plurality of measurement functions between two given instants; by taking only the second values of all pairs and applying a statistical method, a measurement of the frequency would be obtained.

To implement the operations of the method, the system includes an analogue-to-digital (A/D) converter, an anti-aliasing filter, a calculation unit with data processing capability (e.g., a computer, processor circuit, microcontroller, microprocessor, etc.) with associated memory to record the data. In cases where the input signal has a high voltage or current, a conditioner to work at levels of a few volts (V) or amperes (A). Further details and examples are given in the detailed description.

The anti-aliasing filter is used exclusively to avoid coupling the sampling frequency of the A/D converter with the high frequencies that the input signal may contain, which would cause the unrealistic effect of obtaining superimposed low frequencies in the digitised signal. It must be distinguished from other low-pass filters that are usually inserted in other frequency measurement systems, which are intended to filter lower frequencies than the anti-alising filter, as without them their calculation algorithms would not work properly.

**Advantageous Effects of Invention**

An advantage of the technique proposed in the procedure and system is that it does not require sophisticated calculations, very high quality electronics or a very precise timing source. Thus, in certain embodiments, it can be implemented in embedded equipment or integrated circuits.

Another advantage of the proposed technique is that it is highly immune to superimposed disturbances on an input signal, so that, in most circumstances, it can avoid prior filtering to remove them. This results in a lower latency in obtaining the frequency measurement, since any filter adds an inertia between its output and input and therefore a delay in the observability of any variation, including its frequency.

The process and system can operate without external synchronisation and can use low-cost analogue-to-digital (A/D) converters.

The proposed technique can perform the calculations in a short time interval, with a minimum of one cycle of the input signal, which also means better behaviour in the event of amplitude and phase modulations of the signal. This is particularly positive for evaluating the frequency derivative, which is another important parameter for stability control in an equipment or system, and control systems can be implemented that use this variable and counteract an incipient loss of instability sufficiently in advance. Compared to other methods that are based on increasing the number of network cycles in order to obtain more samples and therefore a better estimation of the frequency, this one is based on increasing the number of samples without the need to increase the cycles, which results in better precision for the same calculation time.

In addition, it can optionally give the uncertainty of each measurement, both of the frequency and of its derivative, making it possible to know if each of the calculated values is of sufficient quality, a parameter that can be advantageous to discriminate the accuracy of the calculations with respect to the real physical phenomena. Other systems are unable to determine the uncertainty of each of the reported measurements, relying on laboratory certifications according to specific waveforms, which reduces the confidence in the measurements when there are strong disturbances in the network and it is necessary to operate with confidence and with precision.

The system and method described has multiple applications. For example, it can be applied in medical devices where heart rate monitoring is required. It is also particularly advantageous in power supply systems. In situations where the balance between power generation and power consumption is disturbed and when synchronous generators are used.

They rotate at a nearly constant angular velocity resulting in a nearly constant mains frequency (e.g., 50 or 60 Hertz), if the power consumption increases, the synchronous generators slow down slightly, transforming some of their kinetic energy into electrical energy needed by the loads. This results in a reduction in frequency. The opposite also applies, so that if there is excess production, the generators speed up and the frequency of the grid increases, albeit slightly. If there are generation sets based on renewable sources, in most cases, there is no or very little inertia and there is no damping of power fluctuations. Therefore, the balance between generation and consumption has to be balanced by the system operator, ordering the connection or disconnection of generating sets on the fly. This is a time-consuming operation. If an imbalance occurs abruptly, e.g. after a sudden disturbance, it can lead to a collapse of the entire power system or parts of it. During the time of this process, the frequency can vary quite rapidly. Being able to quickly measure the frequency of the electrical signal and its derivative makes it possible to anticipate and implement measures that are not currently available.

**Brief Description of Drawings**

In order to support the description herein and to help a better understanding of the features of the invention, a set of drawings is attached hereto as an integral part of the description, in which the following is shown for illustrative and non-limiting purposes:

FIG. 1A shows a schematic view of a device according to the invention.

FIG. 1B shows a schematic view of an anti-aliasing low-pass filter.

FIG. 1C shows a schematic view of an embodiment of the device where the physical signal values are sent by a remote unit, removing the conditioning, anti-aliasing filter and analogue-to-digital conversion modules.

FIG. 1D shows a schematic view of an embodiment of the device where the frequency and its derivative are separately transformed into DC voltage or current signals.

FIG. 1E shows a schematic view of an embodiment of the device, where the frequency and its derivative are separately transformed into DC voltage or current signals, as well as where the physical signal values are sent by a remote unit, removing the conditioning, anti-aliasing filter and analogue-to-digital conversion modules.

FIG. 2 shows a diagram of the method for measuring the frequency and derivative of an input signal.

FIG. 3A shows a waveform and its normalised version with amplitude 1.

FIG. 3B shows a normalised waveform and its rectified version, with the mean value and r.m.s. value of the rectified waveform.

FIG. 4A-4C shows schematically three square waves as measurement functions generated by using different thresholds on the same waveform.

FIG. 4D shows an example of a measurement function with crossover levels with hysteresis not symmetrical about the x-axis.

FIG. 4E shows an example of a normalised waveform with a plurality of hysteresis levels symmetrical about the x-axis.

FIGs. 5A-5B show two different methods for calculating the derivative of the frequency.

FIG. 5C graphically depicts the comparison of the above techniques.

FIG. 5D graphically shows the method of obtaining a cloud of points for a level with symmetrical hysteresis with respect to the x-axis (50 Hz signal and 4 Hz/s derivative).

FIG. 5E graphically shows the method of obtaining the cloud of points for a level with non-symmetrical hysteresis with respect to the x-axis (50 Hz signal and 4 Hz/s derivative).

FIG. 5F shows a real case of a cloud of points and its linear regression, with 600 hysteresis levels symmetrical about the x-axis, and a measurement window of 1.5 network cycles (50 Hz signal and 4 Hz/s derivative).

FIG. 6 shows the uncertainty of the frequency measurement versus the number of pairs of symmetrical crossover levels, for two waveforms with different calculation windows, both associated with an input signal coming from the electrical network.

FIGs. 7A-7C show three normalised waveforms with harmonics.

FIG. 8A shows a normalised waveform, amplitude, frequency and phase modulated, and its corresponding square measurement function with a pair of crossover levels C=±0.5.

FIG. 8B shows the actual frequency of the above signal over a 2-second period, and the calculations made by the device using a 40-millisecond calculation window.

## Description of Embodiments

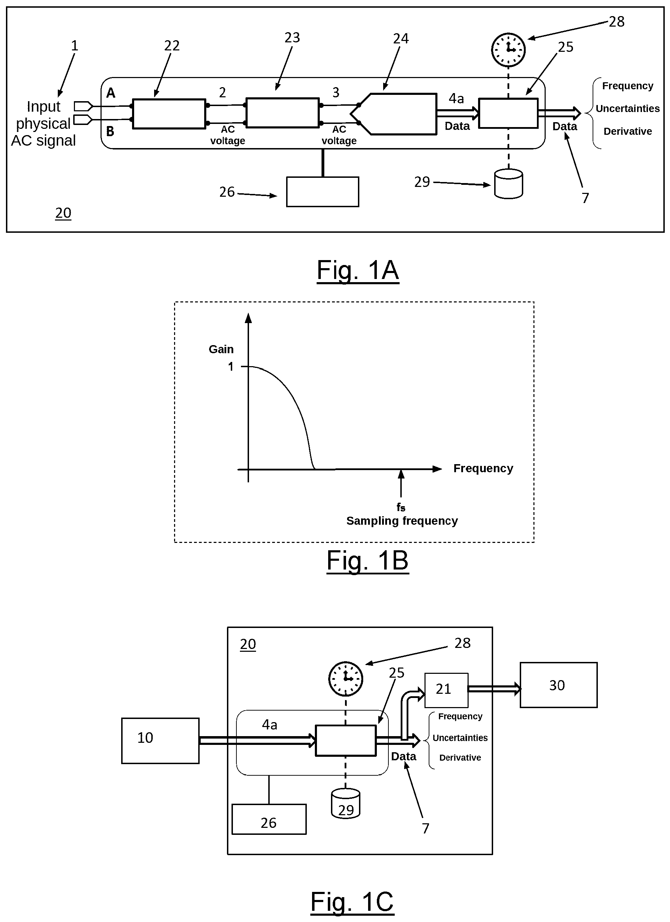

**Fig. 1A** shows an embodiment of the system **20** wherein the method for measuring the frequency and derivative of an alternating voltage or current input signal **1** is carried out. The input signal **1** is connected to terminals A and B of a conditioning circuit **22,** which is responsible for reducing the voltage or current levels of the input signal to voltage levels manageable by the subsequent electronic circuits of the system **20**. This conditioning circuit **22** is connected via two wires to an anti-aliasing filter **23** and this is connected via two wires to an A/D converter **24**. The conditioned signal **2** is filtered to avoid any aliasing phenomena. The filtered signal **3** is fed to the A/D converter **24** which samples the filtered signal **3** at a constant sampling rate $f_s$ obtaining a waveform **4a**. For example, the A/D converter **24** provides an integer value for each sample. In this way, a waveform **4a** corresponding to the input signal **1** is obtained which a computing unit **25** operates on to obtain an estimate of the frequency of the input signal **1** and, optionally, the derivative of the frequency of the input signal **1** and/or the uncertainty associated with the resulting estimation.

Fig. **1B** shows the schematic gain response of a low-pass anti-aliasing filter **3** and its relationship to the sampling frequency $f_s$ to be used in the present system. The anti-aliasing filter **23** prevents high frequency signals from being wrongly detected by the A/D converter **24** as very low frequency signals.

Coming back to Fig. **1A,** in one embodiment the output of the A/D converter **24** is related to the original input signal **1** by a linear function with an offset and a gain, which however need not be known according to the present proposal. The A/D converter **24** may provide a synchronous stream of signed or unsigned integer data to the computing unit **25**. In the case of unsigned integer data, it is necessary to know the integer value representing the zero value of the original signal by subtracting it from each of the measurements of the synchronous data stream. A set of output data **7** relating to the measured frequency, and optionally, the uncertainty and the measured frequency derivative, with a certain number of decimal places, is obtained at the output of the computing unit **25**. The system **20** is fed by a power supply **26**. Optionally, the system may be provided with an external clock **28** which provides timestamps of the output data stream **7** and also allows counteracting the systematic error of the sampling frequency of the A/D converter **24**. With this timestamp, simultaneous measurements can be compared at different sites at the same time.

**Fig. 1C** shows another simplified embodiment of the system **20** in which the signal conditioner, anti-aliasing filter and analogue-to-digital converter are not needed because it works directly in digital format. There is a remote data source **10,** which connects to the computing unit **25,** and provides a sequence or stream of data representing the waveform **4a** corresponding to an analogue signal **1** of which the frequency is to be calculated. In this example, the remote data source **10** directly provides the waveform 4a with which the computing unit **25** operates as input to the system **10**. It is equivalent to the example of **Fig. 1A,** detaching the set of components consisting of the anti-aliasing filter, the A/D converter and the conditioning circuit, and considering that the computing unit is connected to a remote data source which already delivers the waveform as input. The output of system **10** can be fed to a monitoring device **30** to assess whether there is an excessive deviation from the safety ranges associated with the frequency and derivative. In the event of such a deviation, system **10** can generate warnings and alarms so that the monitoring equipment **30** can establish control measures to remedy or mitigate the problem depending on the degree of deviation. Control countermeasures may include selective disconnection of certain loads within an electricity network (load shedding).

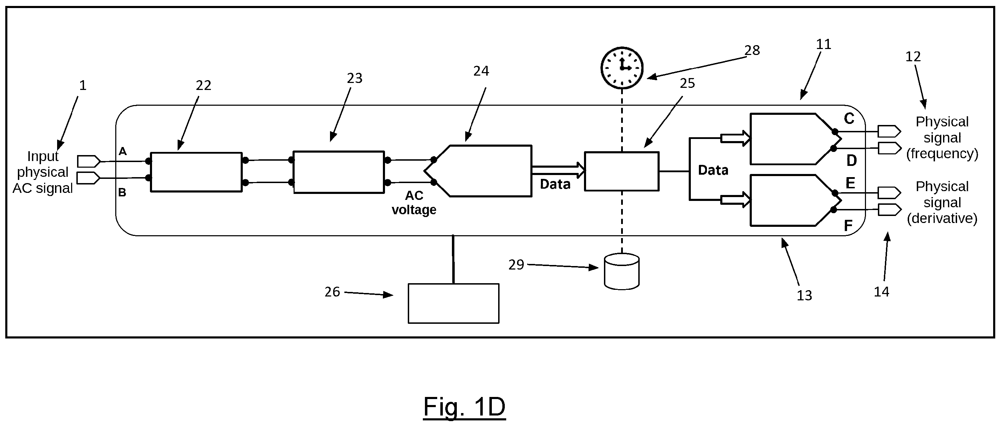

**Fig. 1D** shows another embodiment of the system **20** similar to **Fig. 1A,** where the output of the computing unit **25** is connected to supply data to a first D/A converter **11**. The D/A converter **11** delivers a first electrical signal **12** for the frequency at its terminals C and D, and a second electrical signal **14** for the frequency derivative at its terminals E and F, by means of a second D/A converter 13. These analogue signals **12, 14** are of DC type, in voltage or current, representing a linear relationship with gain and offset, although any type of non-linear function can be implemented, and can be used to control analogue equipment operating with a different relationship to frequency.

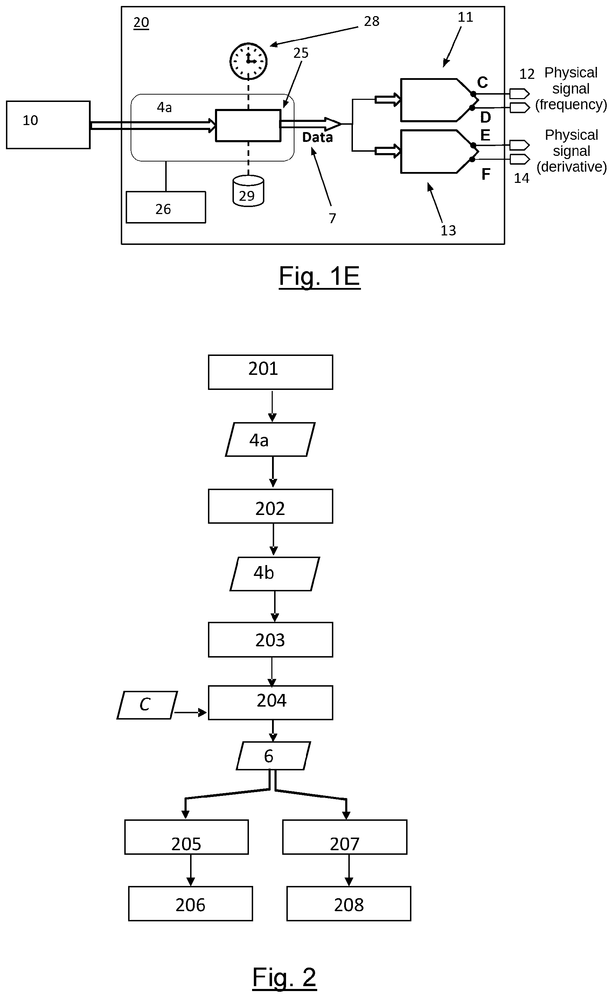

**Fig. 1E** shows another embodiment of the system **20** in which the signal conditioner, anti-aliasing filter and A/D converter are replaced by a remote data source **10** to which the computing unit **25** is connected to receive the waveform **4a**. A first D/A converter **11** and a second D/A converter **13** are connected to the output of the computing unit **25** providing, respectively, analogue DC signals **12, 14,** in voltage or current, which preferably have a linear dependence with a gain and an offset, although it is possible to implement any type of non-linear function as indicated above.

Having described several embodiments of the system **20** where it is possible to implement the procedure for frequency measurement, this latter is explained in more detail.

**Fig. 2** depicts in a schematic way the sequence of the main steps of the frequency measurement procedure.

A step for digitisation **201** of the input signal and obtaining a waveform **4a** for digital processing. If the digital information is available, this step may be omitted.

An optional step of normalizing **202** the waveform **4a** and obtaining a normalised waveform **4b.**

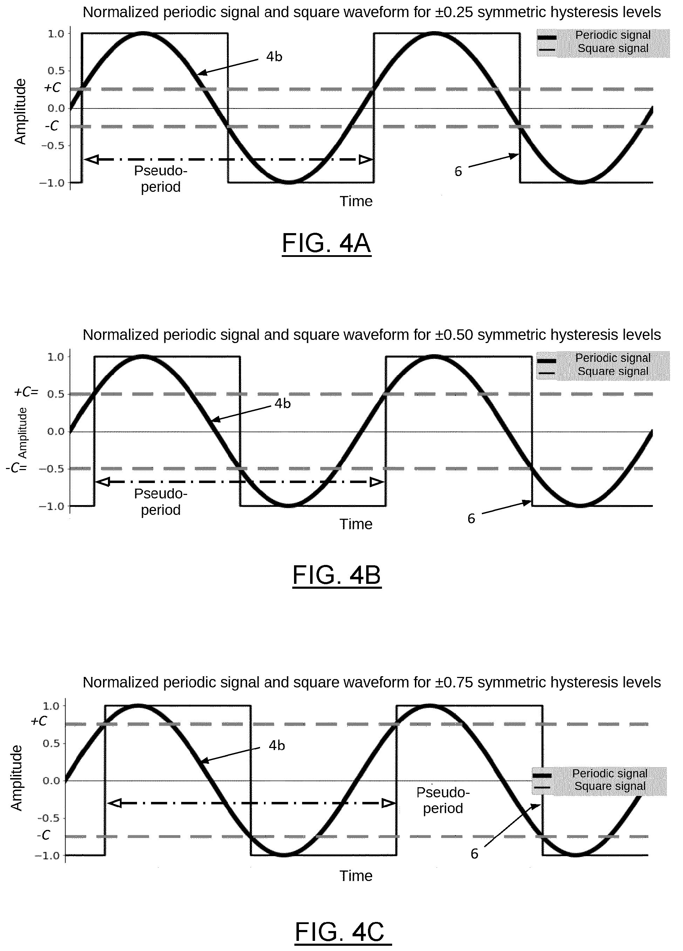

A comparison step **203** of waveform **4a,** or optionally standard **4b,** with several pairs of crossover levels determining a hysteresis condition (user selectable or preset for convenience in a simplified mode of operation). The crossover levels must be within the full scale of waveform **4a** or optionally of its normalised **4b,** so that they intersect with it (may be, for example, $\pm 0.25$, $\pm 0.5$, $\pm 0.75$, +2/+1 as illustrated in **Figs. 4A-4D** or any other).

A generation step **204** of several measurement functions **6,** each one associated with a pair of crossover levels, C. Measurement function **6** is chosen to have a rising edge at a first level and a falling edge at a second level, which change when the waveform coincides with the crossover level and a hysteresis condition is met to avoid bounces. Therefore, the measurement function **6** is repeated according to time intervals which are called periods (mathematically they would be quasi-periods or pseudo-periods) and which may be slightly different from each other. Two consecutive rising or falling edges can be used to establish a period of the measurement function **6.**

If only the frequency of the signal, not its derivative, is to be estimated, a recording step **205** of a set of such periods is performed for each measurement function **6.** Subsequently a statistical calculation step **206** is performed to extract data **7** and obtain estimates of the waveform frequency **4a** and measurement uncertainty, mainly using all periods of all measurement functions generated between two instants.

If it is required to estimate the derivative of the frequency of the signal, a recording step **207** of pairs of values associated with such periods is performed, the first element of each pair being the average time stamp of the period and the second being its difference (i.e., its duration). Step **205** would be identical to step **207** taking into account only the second element of each pair. Subsequently a statistical calculation step **208** to extract data **7** and obtain estimates of the frequency derivative of the waveform **4a** and the measurement uncertainty, mainly using all pairs of values of all measurement functions generated between two instants.

These estimates are used, for example, to assess frequency deviations of an input signal from a nominal or expected value. As a result, it is possible to implement actions to correct such deviations and/or to adapt the operation of equipment to the estimated frequency.

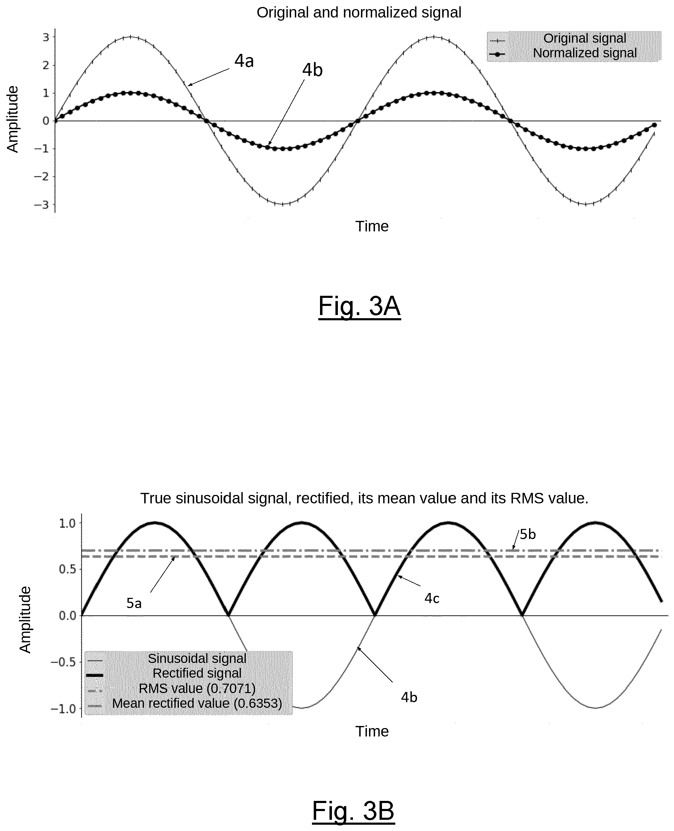

**Figs. 3A** and **3B** show graphically various signals with which the calculation unit **25** works.

**Fig. 3A** shows an example of a sine waveform **4a** which when divided by its amplitude A=3 (constant) becomes a normalised signal **4b.** It is important to normalise waveform **4a** so that amplitude variations are not carried over to the frequency estimation.

If deviations from a nominal amplitude value occur, as in the case of the voltage signal in an electrical distribution network, if not normalised, fluctuations in the real amplitude of the input signal are interpreted as frequency drifts with respect to the nominal frequency by applying the proposed measurement procedure. Normalising resolves this circumstance effectively, although it may increase the uncertainty of the measurement, so it is added as an option and it will be necessary to determine what is to be prioritised in each case.

**Fig. 3B** shows a normalised sine waveform **4b,** where the normalised amplitude is 1, and its rectified version **4c.** According to a first option the rectified mean value **5a** (see formula [1] below, the rectified mean value corresponds to $\alpha$=1) and according to a second option the rms value **5b** (the rms value corresponds to $\alpha$=2 in formula [1]).

In general, the input signal can be normalised according to various techniques. Each of the $x_k$ samples of the input signal is divided by a value representing the amplitude A, yielding an equivalent normalised sample signal $y_k$ whose amplitude will range from approximately -1.0 to +1.0, although in fact it may not reach or exceed these values at some point.

Other examples are to use as amplitude value A the maximum value, or a percentile of the absolute values of the input signal in a calculation interval (typically the 95% or 99% percentile), both of which are easy to implement in an algorithm and are also applicable to signals where there is no nominal or reference frequency (e.g. electrocardiograms).

Equation [1] can be used to generically calculate an amplitude value to normalise the input signal to:

$$A = \frac{\sqrt[\alpha]{\frac{1}{N}\sum_{k=1}^{N}|x_k|^{\alpha}}}{\sqrt[\alpha]{\frac{1}{N}\sum_{k=1}^{N}\left|sin(2\pi f_s^{-1} f_n)\right|^{\alpha}}} \qquad [1]$$

Being $x_k$ is each of the $N$ samples of the input signal in the calculation window, a value is calculated for its normalisation amplitude, which we will call $A$, so that the normalised samples on which the algorithm will be applied will be $x_k/A$.

The value of $\alpha$ can be chosen from any positive value greater than zero, where $f_s$ represents the sampling frequency of the analogue-to-digital converter and $f_n$ the nominal frequency of the signal, e.g. 50 or 60 Hz in public power systems. The most common value for $\alpha$ will be precisely 1, where A represents the ratio of the mean value of the absolute values of the signal to the mean value of the absolute value of a sinusoidal signal of amplitude one at the nominal frequency. A suitable value for $\alpha$ can also be 2, where $A$ represents the ratio of the rms value of the signal to the rms value of a sine wave of amplitude one at the nominal frequency (see **Fig. 3A**). If the maximum level or a percentile of the amplitude is taken, the original samples $x_k$ are taken, sorted by absolute value and the corresponding maximum or percentile value is taken, this being the $A$ value.

**Figs. 4A-4C** show examples of three measurement functions applied simultaneously on the same normalised waveform **4b** during a measurement interval that includes slightly more than one cycle. The measurement functions are square functions **6** that change from high to low depending on the crossover with the normalised waveform **4b**. The crossover levels can be chosen according to different criteria. For simplicity, in this example, the maximum amplitude of the normalised waveform **4b** is divided into four equal segments according to three pais of crossover levels. **Fig. 4A** illustrates the crossover levels: $C=\pm 0.25$, **Fig. 4B** illustrates the crossover levels: $C=\pm 0.50$, **Fig. 4C** illustrates the crossover levels: $C=\pm 0.75$. In other embodiments, it may be desirable to distribute the crossover levels in a non-linear fashion and to concentrate them closer to the x-axis, near zero.

The measurement functions **6** set lines at the positive and negative crossover level (C: $\pm 0.25$, $\pm 0.50$ and $\pm 0.75$); the initial level is taken as +1 or -1 indistinctly (actually, the value of the level of the square function is irrelevant in the calculations, it could be $\pm 1.5$, $\pm 3$, $\pm 4$,...); when the normalised waveform **4b** exceeds the positive threshold and previously the square function has the value -1, then it acquires the value +1. ); when the normalised waveform **4b** exceeds the positive threshold and the square function previously has the value -1, then it takes the value +1; when the waveform **4b** goes below the negative crossing level, -C, and the square function previously has the value +1, then the square function takes the value -1; this process is repeated throughout the calculation interval and for each of the thresholds, thus obtaining the 3 square functions **6**.

The next operation is to calculate periods for these square **6** signals, from the time elapsed between two rising edges or two falling edges.

The following operation is a statistical analysis. Once various periods have been obtained for the square functions 6, in the calculation interval, e.g. to facilitate further operations, their inverse values are calculated and used to generate a data vector $F$.

In a particular case, for the statistical analysis, in order to discard outliers, mean $\mu$ and standard deviation $\sigma$ of the data vector $F$ (of length $n$) are calculated and those values outside the interval $[\mu - \eta \cdot \sigma, \mu + \eta \cdot \sigma]$ are discarded, $\eta$ being a constant value to be chosen between 1.0 and 2.0. Thus, a reduced data vector $\hat{F}$ (of length $\hat{n}$) is obtained, on which its mean $\hat{\mu}$ and standard deviation $\hat{\sigma}$ are recalculated. The calculated frequency value is precisely $\hat{\mu}$ and the measurement uncertainty corresponds to the standard deviation of the mean, $\hat{\sigma}/\sqrt{(\hat{n})}$, which are returned by the calculation unit.

If the number of samples is not large enough or if a faster calculation is desired, $\mu$ can simply be returned as the calculated value of the waveform frequency and $\sigma/\sqrt{n}$ of its uncertainty. This statistical method is outlined in section 4.2 of reference **NPL 3,** as well as in reference **NPL 1.**

To increase the number of values, each square function is started alternately, once with the value +1 and the next time with the value -1. In general, a level m shall be defined which will result in thresholds at the levels $\pm 1/m$, $\pm 2/m$, ..., $\pm (m-1)/m$. The value of $m$ shall be chosen between a minimum value of 3 and a maximum value equal to half the full scale of the analogue-to-digital converter. Depending on the application, this $m$ value may typically be a few tens, or even several hundreds or thousands for applications with very high accuracy and speed requirements.

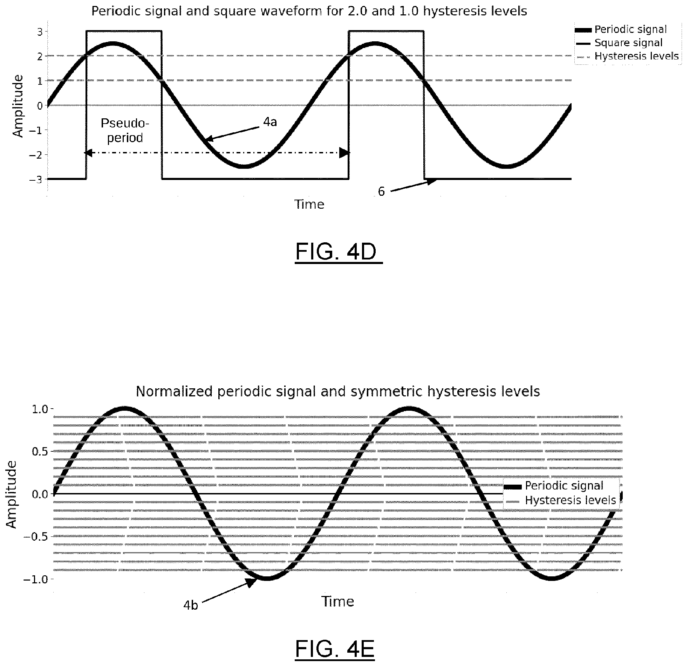

**Fig. 4D** shows an example of a measurement function with crossover levels with non-symmetrical hysteresis with respect to the x-axis, namely +2 and +1, applied on the original signal **4a** without normalisation. As can be seen, the measurement function **6** continues to be generated and its period, understood as the distance between two rising or falling edges, continues to match that of the signal to be measured **4a.** However, the time at high level is no longer the same as that at low level, hence the importance of measuring the distance between two rising or falling edges and not the half-period.

**Fig. 4E** shows an example of a normalised waveform **4b** with 9 hysteresis levels symmetrical about the x-axis and evenly spaced on the y-axis ($\pm 0.1$, $\pm 0.2$, $\pm 0.3$, ..., $\pm 0.9$). In this case, 9 square measurement functions **6** would be generated, which are not depicted in **Fig. 4E** because their superposition would be unintelligible. The statistical calculations would be applied on the set of measurement functions **6** simultaneously, so that the greater the number of overlapping functions **6,** the greater the number of samples and, therefore, the better the measurement of the frequency and/or its derivative.

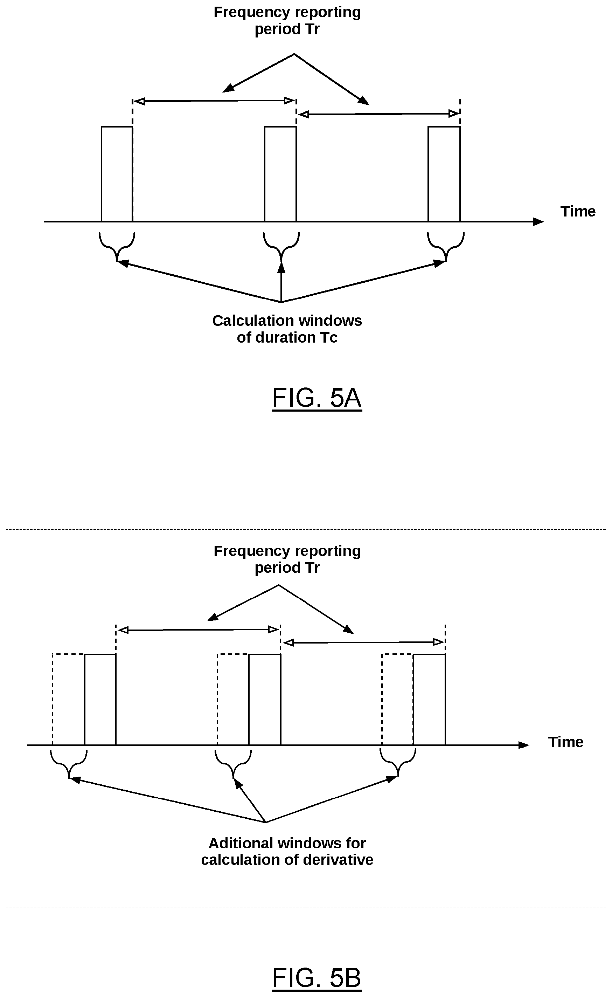

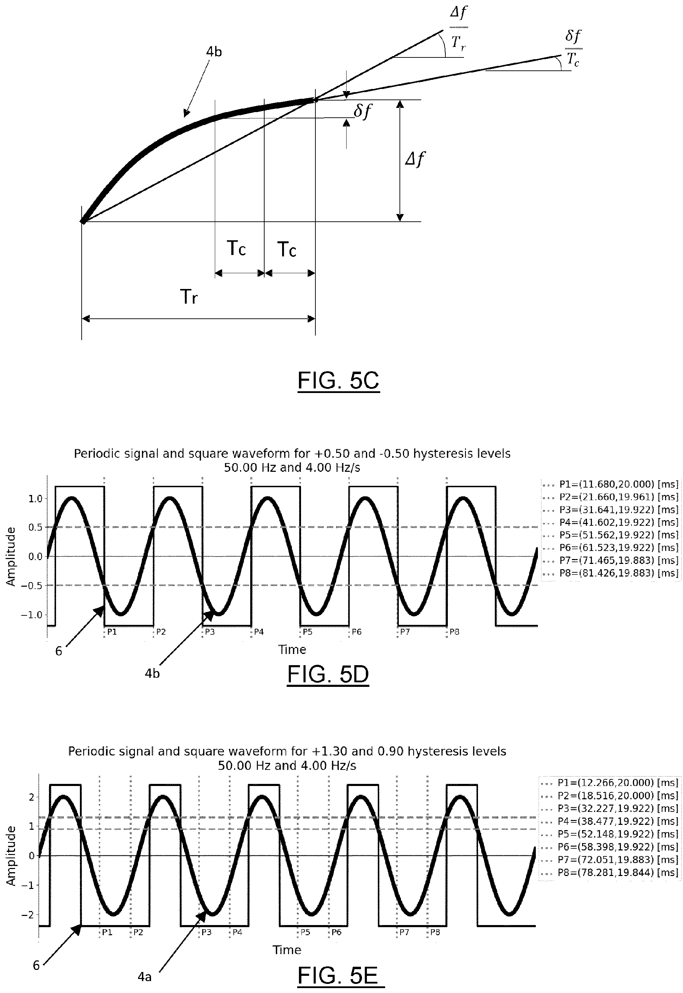

**Figs. 5A-5C** illustrate two methods for calculating the frequency derivative separately **(Figs. 5A, 5B)** and together **(Fig. 5C).**

A first simplified method, as exemplified in **Fig. 5A,** where the frequency measurement does not require additional calculation, by taking the estimated frequencies during two evaluation intervals ($T_r$), calculating the difference ($\Delta f = |f_1 - f_2|$) between the estimated frequency obtained in each evaluation interval $(f_1; f_2)$ and dividing by that evaluation interval:

$$\frac{df}{dt} \approx \frac{\Delta f}{T_r} \quad [2]$$

The measure of derivative of the frequency would correspond to the average slope of the frequency, between the two instants in which two frequency measurements are generated. This derivative measure would therefore have a natural delay given by $T_r$, since it would be necessary to have two consecutive frequency measurements.

A second, faster technique is shown in **Fig. 5B,** where the frequency is calculated in two contiguous windows defined by a calculation interval of width $T_c$, the derivative is calculated as the ratio of the frequency increment ($\delta f$) to the window width $T_c$:

$$\frac{df}{dt} \approx \frac{\delta f}{T_c} \quad [3]$$

It is possible to determine the rate at which a frequency measurement is to be generated by setting an evaluation interval $T_r$. A time window of width $T_c$ is taken just before each time instant where this frequency calculation is to be output.

With respect to the technique in **Fig. 5A,** this measurement of the derivative would have no delay $T_r$, since it would not be necessary to have two frequency measurements separated by this interval.

**Fig. 5C** shows an example of the difference between the two methods for measuring the derivative of frequency. It shows a comparatively better fit to the slope of the derivative curve obtained with the second method. In some embodiments it may be appropriate to implement either the first or the second, or even a combination of both.

**Fig. 5D** graphically shows the method of obtaining the cloud of points for a level with symmetrical hysteresis with respect to the x-axis (50 Hz signal and 4 Hz/s derivative). Four cycles of the normalised waveform **4b** and a pair of symmetrical levels of crossover $C=\pm 0.5$ have been plotted. Having obtained the measurement function **6,** every two consecutive rising or falling edges, a series of points *P1, P2,* up to *P8* are calculated, where each of them has as its first element the average value of the time stamp of the edges and its second element is the difference. The origin of times is arbitrary, being taken as zero precisely at the beginning of the graph for clarity. Each of these points is marked on the graph by a vertical dotted line, with their specific values expressed in milliseconds appearing in the legend. In fact, these vertical lines are virtually indistinguishable from the rising and falling edges of the measurement function **6,** although they would only coincide exactly for symmetrical hysteresis levels and constant frequency waveforms.

**Fig. 5E** graphically shows the method of obtaining the cloud of points for a level with a non-symmetrical hysteresis with respect to the x-axis (50 Hz signal and 4 Hz/s derivative). The case is similar to the previous one and the subsequent statistical calculation is exactly the same, although now it can be seen how the vertical dotted lines corresponding to points *P1, P2,* up to *P8* are perfectly distinguishable from the rising and falling edges of the measurement function **6.**

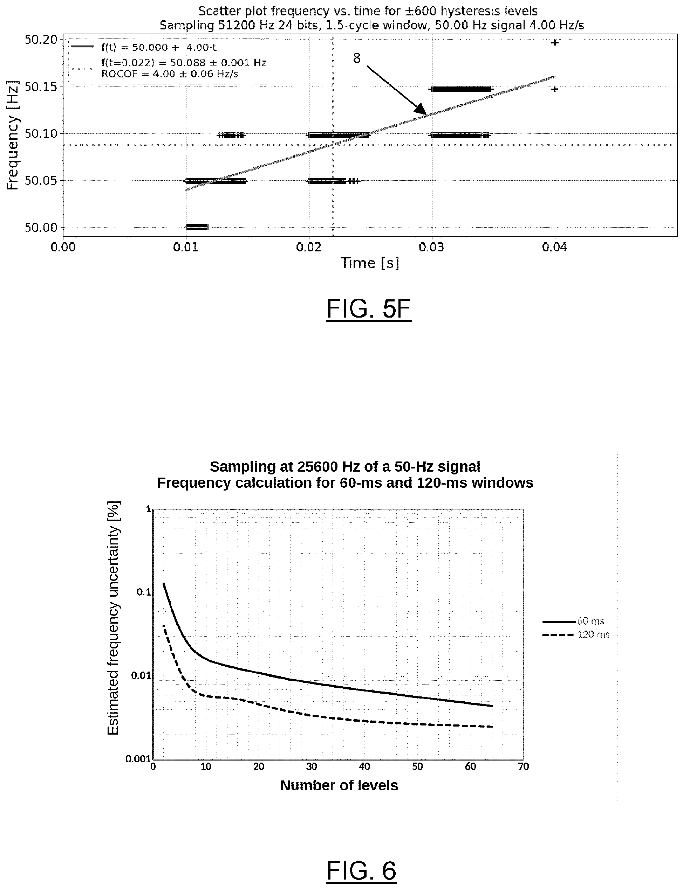

**Fig. 5F** shows graphically the method for calculating the derivative of the frequency of a sine signal of amplitude 1 starting at 50 Hz and whose derivative is 4 Hz/s. In this case the signal is sampled at 51200 Hz (which would correspond to 1024 points per cycle at 50 Hz), with a 24-bit A/D converter and 600 evenly spaced symmetrical crossover levels (levels $\pm 1/600$, $\pm 2/600$, $\pm 3/600$, ..., $\pm 597/600$, $\pm 598/600$ and $\pm 599/600$) are taken. For each of the points P001, P002, P003, ...,

P597, P598 and P599, the second of their elements is inverted to represent a frequency and not a period, and they are represented by crosses on a graph whose abscissa axis corresponds to the time and the ordinate axis to the frequency. Adjusting this cloud of points by a least squares line, a function *f(t)* is obtained whose algebraic expression is *50+4t,* indicating that its constant value is 50 Hz and its slope 4 Hz/s, which corresponds exactly to the frequency derivative of the original signal, demonstrating the reliability and accuracy of the procedure. The mean value of the frequency in the calculation window turns out to be 50.088 Hz and the uncertainty of only 1 mHz. Regarding the derivative, its mean value in the calculation window is the slope of the straight line, 4.00 Hz/s, and its uncertainty is only 0.06 Hz/s. These values are those that would be generated by the calculation unit **25.**

The variance in the estimation of the slope of the regression line is given by the sum of the squares of the residuals of the cloud of points with respect to the regression line (named $SS_E$), divided by *n-2,* where *n* is the number of samples in the cloud of points (see non-patent literature **NPL 2** page 409). Calculating its square root gives its standard deviation, which corresponds to the uncertainty of the derivative of the frequency:

$$ROCOF\ uncertainty = \sqrt{\frac{SS_E}{n-2}} \quad [4]$$

A graph illustrating the relationship between uncertainty and number of pairs o symmetrical hysteresis values is shown in **Fig. 6.** It can be observed how the uncertainty in the measured frequency (using the arithmetic mean) decreases with the number of samples. This is a real case on a waveform corresponding to a 50 Hz public mains voltage signal, for measurement calculation intervals of 60 ms (continuous curve) and 120 ms (dashed curve) and varying the number of pairs of crossover levels between 2 and 64. Theoretically, either the frequency calculation interval or the number of crossover levels can be increased to reduce the uncertainty. In the case where the frequency varies more rapidly, increasing the calculation period would not capture its dynamic character, so for input signals subject to rapid frequency variations it is preferable to increase the number of crossover levels. It is envisaged that in certain implementations it may be user selectable or, in unattended mode, programmed to increase the number automatically, e.g. if the accuracy of the measurement obtained is lower than a set threshold (for quality, regulatory requirement, etc.)..

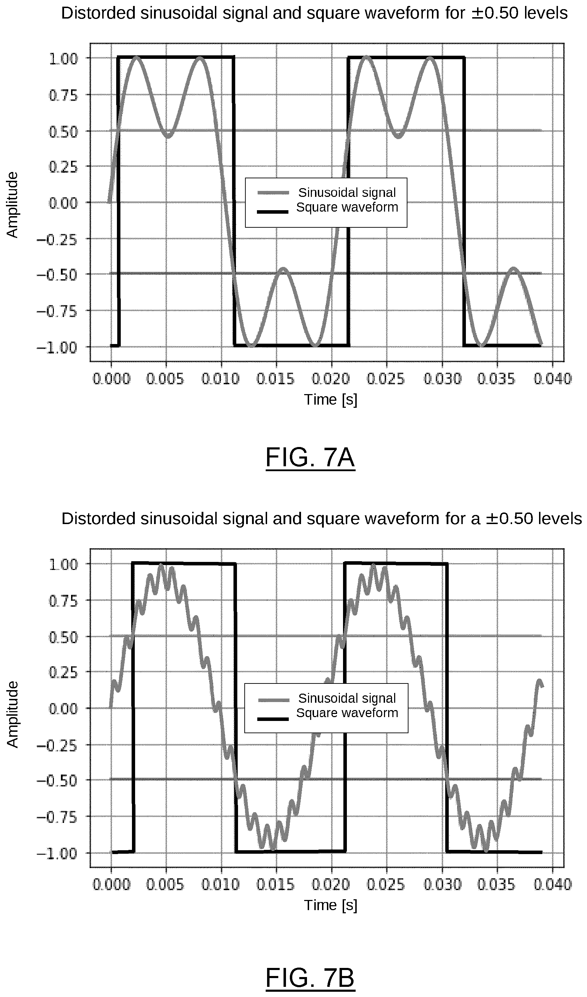

**Figs. 7A-7B** show two waveforms normalised to 1, sinusoidal and both with a very large harmonic component, and crossover levels C=±0.5. It can be seen how the square measurement function is virtually immune to the disturbances present in the waveform. **Fig. 7A** shows a sine wave with a third harmonic whose amplitude is 50% of the fundamental frequency, while **Fig. 7B** shows a sine wave with a harmonic of order 18 and whose amplitude is 10% of the amplitude of the fundamental frequency. Due to the statistical character of the frequency measurement with multiple C-levels, the lack of precision in the crossovers with the different positive and negative levels, inherent in the superposition of the higher frequency components (e.g. harmonics), is naturally balanced by obtaining a value representative of all statistical samples.

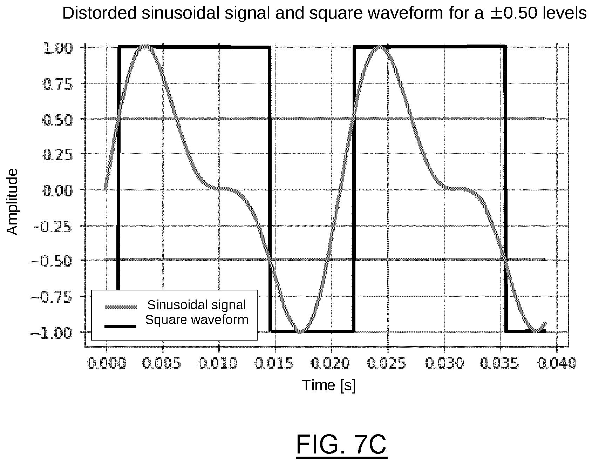

It is also worth mentioning that, since periods, not half-periods, are measured, the amplitude of the positive half-cycles need not be equal to that of the negative ones, something that is particularly visible when the signal has even harmonics. An example of this is shown in **Fig. 7C,** where it can be seen how for a particular case with *C=±0.5* and a second harmonic of 50% amplitude with respect to the fundamental frequency (first harmonic), the squared signal has a substantially larger positive part than the negative part.

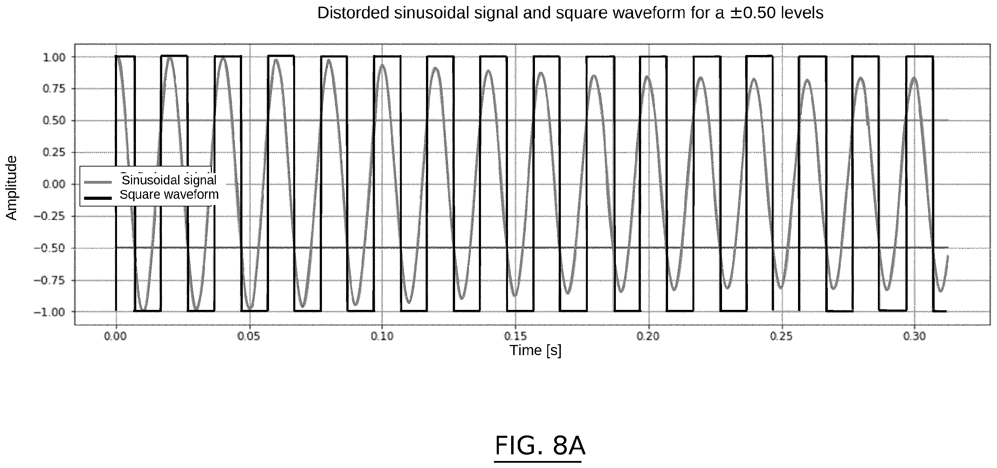

**Fig. 8A** shows a normalised, nominal 50 Hz sine waveform, modulated in amplitude, frequency and phase, with crossover values *C=±0.5* and a corresponding square measurement function. Since there is modulation, the maximum amplitude of the waveform varies with time, even though it is normalised.

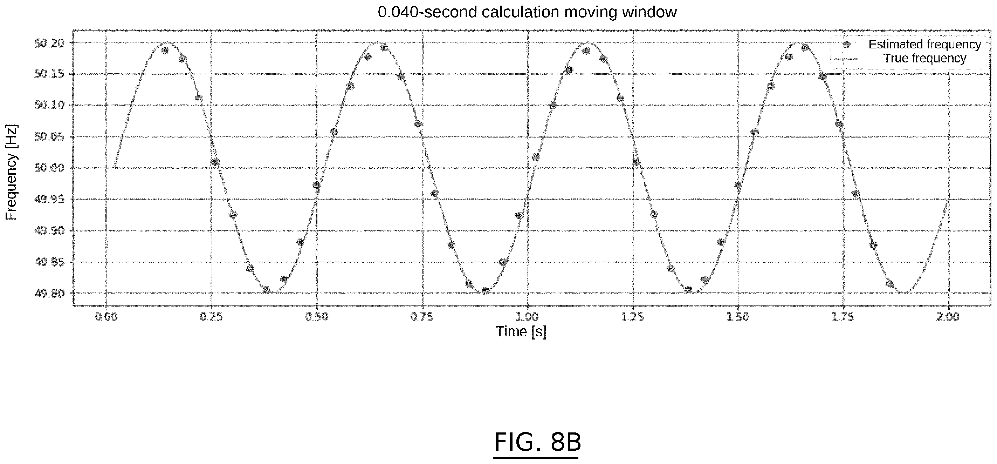

**Fig. 8B** shows the dynamic calculation of the frequency of the waveform in **Fig. 8A** above, with a calculation interval of 40 ms and 40 pairs of crossover values, C, showing how the calculated frequency matches the frequency of the original signal almost perfectly, although the latter varies along with the amplitude and phase.

Finally, if an external clock **28** is available that is more accurate than the A/D converter's own clock, the systematic error of the latter can be corrected. Indeed, by taking at regular time intervals $\Delta T_i$ the number of samples $n_i$ of the A/D converter **24,** the random variable $r_i$, corresponding to the effective sampling frequency of the A/D converter **24,** can be defined as:

$$r_i = \frac{n_i}{T_i} \quad [5]$$

By taking a sufficient number of measurement intervals *N* the mean $\mu$ and standard deviation $\sigma$ of this random

variable can be obtained. The frequency and derivative measurements must then be calculated by taking this mean $\mu$ as the effective value of the A/D converter **24** sampling frequency. The standard deviation of the mean, $\sigma/\sqrt{N}$, gives a measure of the uncertainty of the sampling frequency and should be included in the rest of the uncertainty measurements, either of the frequency or of its derivative, as appropriate.

Alternatively, the external clock **28** may also be used to enhance the values of the rising and falling edge timestamps of the measurement functions **6** by incorporating these enhanced values in the calculation of the frequency and/or its derivative. In this case it would not be necessary to include the uncertainty of the sampling frequency of the A/D converter **24.**

The above description and the enclosed figures are provided as an help to the understanding, separately and in combination, of the features of the invention through various embodiments. The explanations are not to be considered as limiting the scope of the claims. It is to be understood that there are alternative components, devices and configurations to those specifically employed in the explanations and figures without affecting the stated function they perform.

**Reference Signs List**

1 Input signal

2 Conditioned signal

3 Filtered signal

4a Waveform

4b Normalised waveform

5a rectified mean value

5b r.m.s. mean value

6 Measurement function

7 Data stream

8 Regression line

10 Remote data source

11 D/A converter

12 Analogue frequency signal

13 D/A converter

14 Analogue frequency derivative signal

20 System

21 Communication Unit

22 Conditioning Circuit

23 Anti-aliasing filter

24 A/D converter

25 Calculation Unit

26 Power Supply

28 External Clock

29 External storage unit

30 Monitoring equipment

201 Digitisation

202 Normalisation

203 Comparison

204 Generation

205 Recording of periods

206 Statistical frequency calculation

207 Recording of time-period pairs

208 Statistical calculation of frequency and derivative

**Patent Literature**

[PTL 1] GB 2528847 A (DEEP SEA ELECTRONICS PLC) 2014-07-30, the whole document.

[PTL 2] US 7184937 B1 (US ARMY) 2005-07-14, the whole document.

[PTL 3] JP H0943262 A (FUJITSU TEN LTD) 1998-07-28, the whole document.

[PTL 4] US 2017040900 A1 (TOSHIBA MITSUBISHI ELECTRIC INDUSTRIAL SYSTEMS CORP) 2020-01-30, the whole document.

[PTL 5] CN 114217126 A1 (ELECTRIC POWER SCIENCE RES INSTITUTE OF GUANGXI POWER GRID LIMITED RESPONSIBILITY COMPANY) 2022-03-22, the whole document.

[PTL 6] CN 103575979 A (UNIV NANJING POSTS & TELECOMM) 2012-07-26, the whole document.

[PTL 7] CN 102095929 A (UNIV NANJING POSTS & TELECOMM) 2010-12-17, the whole document.

[PTL 8] CN 101871965 A (WASION GROUP CO LTD) 2010-06-11, the whole document.

[PTL 9] CN 102879639 A (UNIV HUAZHONG SCIENCE TECH) 2012-09-13, the whole document.

[PTL 10] CN 1815248 A (AIMOSHENY NETWORK ENERGY SOURC) 2005-02-02, the whole document.

[PTL 11] CN 102116798 A (SHENZHEN RENERGY TECHNOLOGY CO LTD) 2011-03-07, the whole document.

[PTL 12] CN 104360144 A (GUANGDONG MIDEA ENVIRONMENT APPLIANCES MFG CO LTD; MIDEA GROUP CO LTD) 2014-12-08, the whole document.

[PTL 13] CN 109669070 A (CHINA ELECTRONICS HARVEST TECH CO LTD) 2019-01-02, the whole document.

[PTL 14] CN 105259409 A (ANHUI RESOURCE SAVING & ENVIRONMENTAL TECHNOLOGY CO LTD) 2015-10-13, the whole document.

[PTL 15] US 11204377 B2 (SCHWEITZER ENGINEERING LAB INC) 2018-08-28, the whole document.

[PTL 16] JP 2988039 B2 (YOKOKAWA DENKI KK) 1991-08-30, the whole document.[PTL 17] GB 1338980 A (HEBERLEIN & CO AG) 1972-09-01, the whole document.

[PTL 18] US 6417701 B1 (ROCKWELL AUTOMATION TECH INC) 2000-09-29, the whole document.

[PTL 19] US 5019722 A (MOTOROLA INC) 1990-03-05, the whole document.

[PTL 20] US 4480200 A (FUJI XEROX CO LTD) 1982-01-04, the whole document.

[PTL 21] US 11204377 B2 (SCHWEITZER ENGINEERING LAB INC) 2018-08-28, the whole document.

**Non Patent Literature**

[NPL1] Somppi, J. (2011). Applying Measurement Uncertainty To Digital Multimeter Calibration [PowerPoint slides], Fluke's Calibration Business Unit, Fluke Corporation.https://us.flukecal.com/sites/flukecal.com/files/assets/Training_and_Events/us/ web_seminars/uncertainty%20presentation%20-Dec%202011.pdf

[NPL2] Montgomery, D. C., & Runger, G. C. (2010). Applied statistics and probability for engineers 5E binder ready version (pp. 405-410). John Wiley & Sons.

[NPL3] BIPM, IEC, IFCC, ILAC, ISO, IUPAC, IUPAP, and OIML. Evaluation of measurement data - Guide to the expression of uncertainty in measurement. Joint Committee for Guides in Metrology, JCGM 100:2008. URL: https://www.bipm.org/documents/20126/2071204/JCGM_100_2008_E.pdf/cb0ef43f-baa5-11cf-3f85-4dcd86f77bd6.

**Claims**

1. A method for measuring the frequency of a waveform (4a) comprising the steps of:

   - setting a plurality of pairs of crossover levels (C);
   - comparing (203) the waveform (202) with each of the pairs of crossover levels (C) and generating (204) measurement functions (6), wherein each measurement function (6) has a rising edge at a first level and a falling edge at a second level that change according to the coincidence of the waveform (4a) with its pair of crossover levels (C) and a hysteresis condition;
   - recording (205), for each measurement function (6), a plurality of values,
   where each one is defined as the absolute value of the difference of timestamps between two consecutive rising edges or two consecutive falling edges; and
   - performing a statistical calculation (206) on the set of pluralities of values recorded between two given instants of the entire plurality of pairs of crossover levels (C), in order to estimate the frequency of the waveform (4a) between those instants.

2. The method recited in claim 1, **characterised by** further comprising applying a statistical method to obtain the numerical uncertainty of the frequency measurement.

3. A method for measuring the derivative of the waveform frequency (4a) comprising the steps of:

   - setting a plurality of pairs of crossover levels (C);
   - comparing (203) the waveform (202) with each of the pairs of crossover levels (C) and generating (204) measurement functions (6), wherein each measurement function (6) has a rising edge at a first level and a falling edge at a second level that change according to the coincidence of the waveform (4a) with its pair of crossover levels (C) and a hysteresis condition;

EP 4 478 060 B1

- recording (207), for each measurement function (6), a plurality of pairs of values where the first element of each pair is defined as the arithmetic mean of the timestamps between two consecutive rising edges or two consecutive falling edges, while the second element corresponds to the absolute value of their difference; and

- performing a linear approximation statistical method (208) on the set of plurality of pairs of values between two given instants of the entire plurality of crossing levels (C), to estimate from the calculated slope the derivative of the frequency of the waveform (4a) between those instants.

4. The method recited in claim 3, **characterised by** further comprising applying a statistical method to obtain the numerical uncertainty of the frequency derivative measurement.

5. The method recited in any one of claims 1 to 4, wherein each pair of the plurality of pairs of crossover levels (C) consists of a positive number and its opposite (negative), and the hysteresis condition states that:

from the first level it moves on a falling edge towards the second level when the waveform falls below the negative crossover level; and

from the second level it moves on a rising edge towards the first level when the waveform exceeds the positive crossover level.

6. The method recited in any one of claims 1 to 5, wherein the a plurality of crossover levels follows a non-linear distribution on the ordinate axis, with the concentration of crossover levels increasing as the absolute value of the crossover level decreases.

7. The method recited in any one of claims 1 to 6, **characterised by** being applied on a modified amplitude waveform (4b) resulting from normalising (202) the original waveform (4a).

8. The method recited in any one of claims 1 to 7, wherein the waveform is obtained by digitising an input signal (1).

9. The method recited in any one of claims 1 to 8, **characterised by** comprising producing an alarm or warning message if any of the estimated output quantities are outside a safe range.

10. A system for measuring the frequency of a waveform (4a), comprising: a calculation unit (25), capable of receiving and processing data, configured to:

- setting a plurality of pairs of crossover levels (C);

- comparing (203) the waveform (202) with each of the pairs of crossover levels (C) and generating (204) measurement functions (6), wherein each measurement function (6) has a rising edge at a first level and a falling edge at a second level that change according to the coincidence of the waveform (4a) with its pair of crossover levels (C) and a hysteresis condition;

- recording (205), for each measurement function (6), a plurality of values, where each one is defined as the absolute value of the difference of timestamps between two consecutive rising edges or two consecutive falling edges; and

- performing a statistical calculation (206) on the set of pluralities of values recorded between two given instants of the entire plurality of pairs of crossover levels (C), in order to estimate the frequency of the waveform (4a) between those instants.

11. The system recited in claim 10, **characterised by** further comprising applying a statistical method to obtain the numerical uncertainty of the frequency measurement.

12. A system for measuring the frequency derivative of a waveform (4a) comprising:
a calculation unit (25), capable of receiving and processing data, configured to:

- setting a plurality of pairs of crossover levels (C);

- comparing (203) the waveform (202) with each of the pairs of crossover levels (C) and generating (204) measurement functions (6), wherein each measurement function (6) has a rising edge at a first level and a falling edge at a second level that change according to the coincidence of the waveform (4a) with its pais of crossover levels (C) and a hysteresis condition;

- recording (207), for each measurement function (6), a plurality of pairs of values where the first element of each pair is defined as the arithmetic mean of the timestamps between two consecutive rising edges or two consecutive

14

falling edges, while the second element corresponds to the absolute value of their difference; and
- performing a linear approximation statistical method (208) on the set of plurality of pairs of values between two given instants of the entire plurality of pairs of crossing levels (C), to estimate from the calculated slope the derivative of the frequency of the waveform (4a) between those instants.

13. A system recited in claim 12, **characterised by** further comprising applying a statistical method to obtain the numerical uncertainty of the frequency derivative measurement.

14. A system recited in any one of claims 10 to 13, wherein each pair of the plurality of pairs of crossover levels (C) consists of a positive number and its opposite (negative), and the hysteresis condition states that:

from the first level it moves on a falling edge towards the second level when the waveform falls below the negative crossover level; and
from the second level it moves on a rising edge towards the first level when the waveform exceeds the positive crossover level.

15. The system recited in at least one of claims 10 to 14, **characterised in that** its calculation unit (25) is further configured to:

- normalising (202) the waveform (4a) and obtaining a normalised waveform (4b) from received data;

16. The system recited in at least one of claims 10 to 15, **characterised by** further comprising an anti-aliasing filter (23) and an A/D converter (24), wherein the waveform (4a) is obtained from an input signal (1), after being filtered with the anti-aliasing filter (23) and digitised with the A/D converter (24).

17. The system recited in at least one of claims 10 a 16, **characterised by** further comprising a clock (28) configured to be read by the calculation unit (25) and to associate a timestamp to data (7) corresponding to the measured frequency and/or its derivative and/or to the timestamps of the edges of the measurement function (6).

18. A system recited in claim 17, **characterized by** further comprising applying a statistical method to obtain the value of the sampling frequency of the A/D converter (24) and its numerical uncertainty.

19. The system recited in at least one of claims 10 to 18, **characterised by** further comprising:

- a D/A converter (11) configured to output an analogue signal, in voltage or current, of a value equal to the estimated frequency of the waveform (4a);
- a D/A converter (13) configured to output an analogue signal, in voltage or current, of a value equal to the estimated frequency derivative of the waveform (4a).

20. The system recited in at least one of claims 10 to 19, **characterised by** comprising a communications unit (21) for producing an alarm or warning message if any of the estimated output quantities are outside a safe range.

**Patentansprüche**

1. Verfahren zum Messen der Frequenz einer Wellenform (4a), das die folgenden Schritte umfasst:

- Einstellen einer Vielzahl von Paaren von Überkreuzungspegeln (C);
- Vergleichen (203) der Wellenform (202) mit jedem der Paare von Überkreuzungspegeln (C) und Erzeugen (204) von Messfunktionen (6), wobei jede Messfunktion (6) eine ansteigende Flanke bei einem ersten Pegel und eine abfallende Flanke bei einem zweiten Pegel aufweist, die sich entsprechend der Koinzidenz der Wellenform (4a) mit ihrem Paar von Überkreuzungspegeln (C) und einer Hysteresebedingung ändern;
- Aufzeichnen (205), für jede Messfunktion (6), einer Vielzahl von Werten, wobei jeder als der absolute Wert der Differenz der Zeitstempel zwischen zwei aufeinanderfolgenden steigenden Flanken oder zwei aufeinanderfolgenden fallenden Flanken definiert ist; und
- Durchführen einer statistischen Berechnung (206) mit dem Satz von Mehrzahlen von Werten, die zwischen zwei gegebenen Zeitpunkten der gesamten Mehrzahl von Paaren von Überkreuzungspegeln (C) aufgezeichnet wurden, um die Frequenz der Wellenform (4a) zwischen diesen Zeitpunkten zu schätzen.

2. Verfahren nach Anspruch 1, **dadurch gekennzeichnet, dass** es ferner die Anwendung eines statistischen Verfahrens umfasst, um die numerische Unsicherheit der Frequenzmessung zu erhalten.

3. Verfahren zum Messen der Ableitung der Wellenformfrequenz (4a), das die folgenden Schritte umfasst:

   - Einstellen einer Vielzahl von Paaren von Überkreuzungspegeln (C);
   - Vergleichen (203) der Wellenform (202) mit jedem der Paare von Überkreuzungspegeln (C) und Erzeugen (204) von Messfunktionen (6), wobei jede Messfunktion (6) eine ansteigende Flanke bei einem ersten Pegel und eine abfallende Flanke bei einem zweiten Pegel aufweist, die sich entsprechend der Koinzidenz der Wellenform (4a) mit ihrem Paar von Überkreuzungspegeln (C) und einer Hysteresebedingung ändern;
   - Aufzeichnen (207), für jede Messfunktion (6), einer Vielzahl von Wertepaaren, wobei das erste Element jedes Paares als das arithmetische Mittel der Zeitstempel zwischen zwei aufeinanderfolgenden steigenden Flanken oder zwei aufeinanderfolgenden fallenden Flanken definiert ist, während das zweite Element dem Absolutwert ihrer Differenz entspricht; und
   - Durchführen eines statistischen Verfahrens der linearen Annäherung (208) an der Menge der Vielzahl von Wertepaaren zwischen zwei gegebenen Zeitpunkten der gesamten Vielzahl von Kreuzungspegeln (C), um aus der berechneten Steigung die Ableitung der Frequenz der Wellenform (4a) zwischen diesen Zeitpunkten zu schätzen.

4. Verfahren nach Anspruch 3, **dadurch gekennzeichnet, dass** es ferner die Anwendung eines statistischen Verfahrens umfasst, um die numerische Unsicherheit der Messung der Frequenzableitung zu erhalten.

5. Verfahren nach einem der Ansprüche 1 bis 4, wobei jedes Paar der Vielzahl von Paaren von Überkreuzungspegeln (C) aus einer positiven Zahl und ihrem Gegenteil (negativ) besteht, und die Hysteresebedingung besagt, dass:

   vom ersten Pegel eine fallende Flanke zum zweiten Pegel erfolgt, wenn die Wellenform unter den negativen Crossover-Pegel fällt; und
   sich vom zweiten Pegel mit einer steigenden Flanke zum ersten Pegel bewegt, wenn die Wellenform den positiven Crossover-Pegel überschreitet.

6. Verfahren nach einem der Ansprüche 1 bis 5, bei dem die Mehrzahl der Überkreuzungspegel einer nichtlinearen Verteilung auf der Ordinatenachse folgt, wobei die Konzentration der Überkreuzungspegel mit abnehmendem Absolutwert des Überkreuzungspegels zunimmt.

7. Verfahren nach einem der Ansprüche 1 bis 6, **dadurch gekennzeichnet, dass** es auf eine modifizierte Amplitudenwellenform (4b) angewendet wird, die sich aus der Normalisierung (202) der ursprünglichen Wellenform (4a) ergibt.

8. Verfahren nach einem der Ansprüche 1 bis 7, wobei die Wellenform durch Digitalisieren eines Eingangssignals (1) erhalten wird.

9. Verfahren nach einem der Ansprüche 1 bis 8, **dadurch gekennzeichnet, dass** es die Erzeugung einer Alarm- oder Warnmeldung umfasst, wenn eine der geschätzten Ausgangsgrößen außerhalb eines sicheren Bereichs liegt.

10. Ein System zur Messung der Frequenz einer Wellenform (4a), das Folgendes umfasst:
    eine Recheneinheit (25), die in der Lage ist, Daten zu empfangen und zu verarbeiten, und die konfiguriert ist, um:

    - Einstellen einer Vielzahl von Paaren von Überkreuzungspegeln (C);
    - Vergleichen (203) der Wellenform (202) mit jedem der Paare von Überkreuzungspegeln (C) und Erzeugen (204) von Messfunktionen (6), wobei jede Messfunktion (6) eine ansteigende Flanke bei einem ersten Pegel und eine abfallende Flanke bei einem zweiten Pegel aufweist, die sich entsprechend der Koinzidenz der Wellenform (4a) mit ihrem Paar von Überkreuzungspegeln (C) und einer Hysteresebedingung ändern;
    - Aufzeichnen (205), für jede Messfunktion (6), einer Vielzahl von Werten, wobei jeder als der absolute Wert der Differenz der Zeitstempel zwischen zwei aufeinanderfolgenden steigenden Flanken oder zwei aufeinanderfolgenden fallenden Flanken definiert ist; und
    - Durchführen einer statistischen Berechnung (206) mit dem Satz von Mehrzahlen von Werten, die zwischen zwei gegebenen Zeitpunkten der gesamten Mehrzahl von Paaren von Überkreuzungspegeln (C) aufgezeichnet wurden, um die Frequenz der Wellenform (4a) zwischen diesen Zeitpunkten zu schätzen.

**11.** System nach Anspruch 10, **dadurch gekennzeichnet, dass** es ferner die Anwendung eines statistischen Verfahrens umfasst, um die numerische Unsicherheit der Frequenzmessung zu erhalten.

**12.** System zur Messung der Frequenzableitung einer Wellenform (4a), umfassend:
eine Recheneinheit (25), die in der Lage ist, Daten zu empfangen und zu verarbeiten, und die konfiguriert ist, um:

- Einstellen einer Vielzahl von Paaren von Überkreuzungspegeln (C);
- Vergleichen (203) der Wellenform (202) mit jedem der Paare von Überkreuzungspegeln (C) und Erzeugen (204) von Messfunktionen (6), wobei jede Messfunktion (6) eine ansteigende Flanke bei einem ersten Pegel und eine abfallende Flanke bei einem zweiten Pegel aufweist, die sich entsprechend der Koinzidenz der Wellenform (4a) mit ihren Paaren von Überkreuzungspegeln (C) und einer Hysteresebedingung ändern;
- Aufzeichnen (207) einer Vielzahl von Wertepaaren für jede Messfunktion (6), wobei das erste Element jedes Paares als das arithmetische Mittel der Zeitstempel zwischen zwei aufeinanderfolgenden steigenden Flanken oder zwei aufeinanderfolgenden fallenden Flanken definiert ist, während das zweite Element dem Absolutwert ihrer Differenz entspricht; und
- Durchführen eines statistischen Verfahrens der linearen Annäherung (208) an der Menge der Vielzahl von Wertepaaren zwischen zwei gegebenen Zeitpunkten der gesamten Vielzahl von Paaren von Kreuzungspegeln (C), um aus der berechneten Steigung die Ableitung der Frequenz der Wellenform (4a) zwischen diesen Zeitpunkten zu schätzen.

**13.** System nach Anspruch 12, **dadurch gekennzeichnet, dass** es ferner die Anwendung eines statistischen Verfahrens umfasst, um die numerische Unsicherheit der Messung der Frequenzableitung zu erhalten.

**14.** System nach einem der Ansprüche 10 bis 13, wobei jedes Paar der Vielzahl von Paaren von Überkreuzungspegeln (C) aus einer positiven Zahl und ihrem Gegenteil (negativ) besteht und die Hysteresebedingung besagt, dass:

vom ersten Pegel bewegt sie sich auf einer fallenden Flanke zum zweiten Pegel, wenn die Wellenform unter den negativen Überkreuzungspegel fällt; und
sich vom zweiten Pegel mit einer steigenden Flanke zum ersten Pegel bewegt, wenn die Wellenform den positiven Crossover-Pegel überschreitet.

**15.** System nach mindestens einem der Ansprüche 10 bis 14, **dadurch gekennzeichnet, dass** seine Berechnungseinheit (25) ferner so konfiguriert ist, dass sie:

- Normalisieren (202) der Wellenform (4a) und Erhalten einer normalisierten Wellenform (4b) aus empfangenen Daten;

**16.** System nach mindestens einem der Ansprüche 10 bis 15, **dadurch gekennzeichnet, dass** es ferner einen Anti-Aliasing-Filter (23) und einen A/D-Wandler (24) umfasst, wobei die Wellenform (4a) aus einem Eingangssignal (1) erhalten wird, nachdem sie mit dem Anti-Aliasing-Filter (23) gefiltert und mit dem A/D-Wandler (24) digitalisiert wurde.

**17.** System nach mindestens einem der Ansprüche 10 bis 16, **dadurch gekennzeichnet, dass** es ferner eine Uhr (28) umfasst, die so konfiguriert ist, dass sie von der Berechnungseinheit (25) gelesen wird und den Daten (7), die der gemessenen Frequenz und/oder ihrer Ableitung und/oder den Zeitstempeln der Flanken der Messfunktion (6) entsprechen, einen Zeitstempel zuordnet.

**18.** System nach Anspruch 17, **dadurch gekennzeichnet, dass** es ferner die Anwendung eines statistischen Verfahrens umfasst, um den Wert der Abtastfrequenz des A/D-Wandlers (24) und seine numerische Unsicherheit zu erhalten.

**19.** System nach mindestens einem der Ansprüche 10 bis 18, **dadurch gekennzeichnet, dass** es ferner umfasst:

- einen D/A-Wandler (11), der so konfiguriert ist, dass er ein analoges Spannungs- oder Stromsignal mit einem Wert ausgibt, der der geschätzten Frequenz der Wellenform (4a) entspricht;
- einen D/A-Wandler (13), der so konfiguriert ist, dass er ein analoges Signal in Form von Spannung oder Strom mit einem Wert ausgibt, der der geschätzten Frequenzableitung der Wellenform (4a) entspricht.

**20.** System nach mindestens einem der Ansprüche 10 bis 19, **dadurch gekennzeichnet, dass** es eine Kommunikationseinheit (21) zur Erzeugung einer Alarm- oder Warnmeldung umfasst, wenn eine der geschätzten Ausgangsgrößen außerhalb eines sicheren Bereichs liegt.

**Revendications**

1. Méthode de mesure de la fréquence d'une forme d'onde (4a) comprenant les étapes suivantes

   - définir une pluralité de paires de niveaux de croisement (C) ;
   - comparer (203) la forme d'onde (202) avec chacune des paires de niveaux de croisement (C) et générer (204) des fonctions de mesure (6), dans lesquelles chaque fonction de mesure (6) a un front montant à un premier niveau et un front descendant à un second niveau qui changent en fonction de la coïncidence de la forme d'onde (4a) avec sa paire de niveaux de croisement (C) et d'une condition d'hystérésis ;
   - enregistrer (205), pour chaque fonction de mesure (6), une pluralité de valeurs, chacune d'elles étant définie comme la valeur absolue de la différence des horodatages entre deux fronts montants consécutifs ou deux fronts descendants consécutifs ; et
   - effectuer un calcul statistique (206) sur l'ensemble des pluralités de valeurs enregistrées entre deux instants donnés de la pluralité entière de paires de niveaux de croisement (C), afin d'estimer la fréquence de la forme d'onde (4a) entre ces instants.

2. Méthode décrite dans la revendication 1, **caractérisée par le fait qu'**elle comprend en outre l'application d'une méthode statistique pour obtenir l'incertitude numérique de la mesure de la fréquence.

3. Méthode de mesure de la dérivée de la fréquence de la forme d'onde (4a) comprenant les étapes suivantes

   - définir plusieurs paires de niveaux de croisement (C) ;
   - comparer (203) la forme d'onde (202) avec chacune des paires de niveaux de croisement (C) et générer (204) des fonctions de mesure (6), dans lesquelles chaque fonction de mesure (6) a un front montant à un premier niveau et un front descendant à un second niveau qui changent en fonction de la coïncidence de la forme d'onde (4a) avec sa paire de niveaux de croisement (C) et d'une condition d'hystérésis ;
   - enregistrer (207), pour chaque fonction de mesure (6), une pluralité de paires de valeurs où le premier élément de chaque paire est défini comme la moyenne arithmétique des horodatages entre deux fronts montants consécutifs ou deux fronts descendants consécutifs, tandis que le second élément correspond à la valeur absolue de leur différence ; et
   - exécuter une méthode statistique d'approximation linéaire (208) sur l'ensemble de la pluralité de paires de valeurs entre deux instants donnés de la pluralité entière de niveaux de franchissement (C), pour estimer, à partir de la pente calculée, la dérivée de la fréquence de la forme d'onde (4a) entre ces instants.

4. Méthode décrite dans la revendication 3, **caractérisée par le fait qu'**elle comprend en outre l'application d'une méthode statistique pour obtenir l'incertitude numérique de la mesure de la dérivée de la fréquence.

5. Méthode décrite dans l'une quelconque des revendications 1 à 4, dans laquelle chaque paire de la pluralité de paires de niveaux de croisement (C) est constituée d'un nombre positif et de son opposé (négatif), et la condition d'hystérésis stipule que :

   à partir du premier niveau, il se déplace sur un front descendant vers le deuxième niveau lorsque la forme d'onde tombe en dessous du niveau de croisement négatif ; et
   à partir du deuxième niveau, il se déplace sur un front ascendant vers le premier niveau lorsque la forme d'onde dépasse le niveau de croisement positif.

6. La méthode décrite dans l'une des revendications 1 à 5, dans laquelle la pluralité de niveaux de croisement suit une distribution non linéaire sur l'axe des ordonnées, la concentration des niveaux de croisement augmentant à mesure que la valeur absolue du niveau de croisement diminue.

7. La méthode décrite dans l'une des revendications 1 à 6, **caractérisée par le fait qu'**elle est appliquée à une forme d'onde d'amplitude modifiée (4b) résultant de la normalisation (202) de la forme d'onde originale (4a).

8. Méthode décrite dans l'une des revendications 1 à 7, dans laquelle la forme d'onde est obtenue par numérisation d'un signal d'entrée (1).

**9.** La méthode décrite dans l'une des revendications 1 à 8, **caractérisée par** la production d'une alarme ou d'un message d'avertissement si l'une des quantités de sortie estimées se situe en dehors d'une plage de sécurité.

**10.** Système de mesure de la fréquence d'une forme d'onde (4a), comprenant une unité de calcul (25), capable de recevoir et de traiter des données, configurée pour :

- définir une pluralité de paires de niveaux de croisement (C) ;
- comparer (203) la forme d'onde (202) avec chacune des paires de niveaux de croisement (C) et générer (204) des fonctions de mesure (6), dans lesquelles chaque fonction de mesure (6) présente un front montant à un premier niveau et un front descendant à un second niveau qui changent en fonction de la coïncidence de la forme d'onde (4a) avec sa paire de niveaux de croisement (C) et d'une condition d'hystérésis ;
- enregistrer (205), pour chaque fonction de mesure (6), une pluralité de valeurs, chacune d'elles étant définie comme la valeur absolue de la différence des horodatages entre deux fronts montants consécutifs ou deux fronts descendants consécutifs ; et
- effectuer un calcul statistique (206) sur l'ensemble des pluralités de valeurs enregistrées entre deux instants donnés de la pluralité entière de paires de niveaux de croisement (C), afin d'estimer la fréquence de la forme d'onde (4a) entre ces instants.

**11.** Système décrit dans la revendication 10, **caractérisé par le fait qu'**il comprend en outre l'application d'une méthode statistique pour obtenir l'incertitude numérique de la mesure de la fréquence.

**12.** Système de mesure de la dérivée de fréquence d'une forme d'onde (4a) comprenant :

une unité de calcul (25), capable de recevoir et de traiter des données,
configurée pour :

- établir une pluralité de paires de niveaux de croisement (C) ;
- comparer (203) la forme d'onde (202) avec chacune des paires de niveaux de croisement (C) et générer (204) des fonctions de mesure (6), dans lesquelles chaque fonction de mesure (6) présente un front montant à un premier niveau et un front descendant à un second niveau qui changent en fonction de la coïncidence de la forme d'onde (4a) avec ses paires de niveaux de croisement (C) et d'une condition d'hystérésis ;
- enregistrer (207), pour chaque fonction de mesure (6), une pluralité de paires de valeurs où le premier élément de chaque paire est défini comme la moyenne arithmétique des horodatages entre deux fronts montants consécutifs ou deux fronts descendants consécutifs, tandis que le second élément correspond à la valeur absolue de leur différence ; et
- exécuter une méthode statistique d'approximation linéaire (208) sur l'ensemble de la pluralité de paires de valeurs entre deux instants donnés de la pluralité entière de paires de niveaux de franchissement (C), pour estimer, à partir de la pente calculée, la dérivée de la fréquence de la forme d'onde (4a) entre ces instants.

**13.** Système décrit dans la revendication 12, **caractérisé par le fait qu'**il comprend en outre l'application d'une méthode statistique pour obtenir l'incertitude numérique de la mesure de la dérivée de la fréquence.

**14.** Système décrit dans l'une quelconque des revendications 10 à 13, dans lequel chaque paire de la pluralité de paires de niveaux de croisement (C) consiste en un nombre positif et son opposé (négatif), et la condition d'hystérésis stipule que :

à partir du premier niveau, il se déplace sur un front descendant vers le deuxième niveau lorsque la forme d'onde tombe en dessous du niveau de croisement négatif ; et
à partir du deuxième niveau, il se déplace sur un front ascendant vers le premier niveau lorsque la forme d'onde dépasse le niveau de croisement positif.

**15.** Le système décrit dans au moins une des revendications 10 à 14, **caractérisé par le fait que** son unité de calcul (25) est en outre configurée pour :

- normaliser (202) la forme d'onde (4a) et obtenir une forme d'onde normalisée (4b) à partir des données reçues ;

**16.** Le système décrit dans au moins une des revendications 10 à 15, **caractérisé par le fait qu'**il comprend en outre un filtre anti-repliement (23) et un convertisseur A/N (24), dans lequel la forme d'onde (4a) est obtenue à partir d'un signal d'entrée (1), après avoir été filtrée avec le filtre anti-repliement (23) et numérisée avec le convertisseur A/N (24).

17. Système selon l'une au moins des revendications 10 à 16, **caractérisé par le fait qu'**il comprend en outre une horloge (28) configurée pour être lue par l'unité de calcul (25) et pour associer un horodatage aux données (7) correspondant à la fréquence mesurée et/ou à sa dérivée et/ou aux horodatages des fronts de la fonction de mesure (6).

18. Système selon la revendication 17, **caractérisé par le fait qu'**il comprend en outre l'application d'une méthode statistique pour obtenir la valeur de la fréquence d'échantillonnage du convertisseur A/N (24) et son incertitude numérique.

19. Système visé dans au moins une des revendications 10 à 18, **caractérisé par le fait qu'**il comprend en outre

   - un convertisseur N/A (11) configuré pour délivrer un signal analogique, en tension ou en courant, d'une valeur égale à la fréquence estimée de la forme d'onde (4a) ;
   - un convertisseur N/A (13) configuré pour délivrer un signal analogique, en tension ou en courant, d'une valeur égale à la dérivée de fréquence estimée de la forme d'onde (4a).

20. Le système décrit dans l'une au moins des revendications 10 à 19, **caractérisé par le fait qu'**il comprend une unité de communication (21) pour produire un message d'alarme ou d'avertissement si l'une des quantités de sortie estimées est en dehors d'une plage de sécurité.

Fig. 1A

Fig. 1B

Fig. 1C

Fig. 1D

EP 4 478 060 B1

Fig. 1E

Fig. 2

Original and normalized signal

## Fig. 3A

True sinusoidal signal, rectified, its mean value and its RMS value.

## Fig. 3B

Normalized periodic signal and square waveform for ±0.25 symmetric hysteresis levels

FIG. 4A

Normalized periodic signal and square waveform for ±0.50 symmetric hysteresis levels

FIG. 4B

Normalized periodic signal and square waveform for ±0.75 symmetric hysteresis levels

FIG. 4C

Periodic signal and square waveform for 2.0 and 1.0 hysteresis levels

Periodic signal
Square signal
Hysteresis levels

Amplitude

Pseudo-period

4a

6

Time

## FIG. 4D

Normalized periodic signal and symmetric hysteresis levels

Periodic signal
Hysteresis levels

Amplitude

4b

Time

## FIG. 4E

Frequency reporting
period Tr

Time

Calculation windows
of duration Tc

## FIG. 5A

Frequency reporting
period Tr

Time

Aditional windows for
calculation of derivative

## FIG. 5B

FIG. 5C

Periodic signal and square waveform for +0.50 and -0.50 hysteresis levels
50.00 Hz and 4.00 Hz/s

P1=(11.680,20.000) [ms]
P2=(21.660,19.961) [ms]
P3=(31.641,19.922) [ms]
P4=(41.602,19.922) [ms]
P5=(51.562,19.922) [ms]
P6=(61.523,19.922) [ms]
P7=(71.465,19.883) [ms]
P8=(81.426,19.883) [ms]

FIG. 5D

Periodic signal and square waveform for +1.30 and 0.90 hysteresis levels
50.00 Hz and 4.00 Hz/s

P1=(12.266,20.000) [ms]
P2=(18.516,20.000) [ms]
P3=(32.227,19.922) [ms]
P4=(38.477,19.922) [ms]
P5=(52.148,19.922) [ms]
P6=(58.398,19.922) [ms]
P7=(72.051,19.883) [ms]
P8=(78.281,19.844) [ms]

FIG. 5E

Scatter plot frequency vs. time for ±600 hysteresis levels
Sampling 51200 Hz 24 bits, 1.5-cycle window, 50.00 Hz signal 4.00 Hz/s

$f(t) = 50.000 + 4.00 \cdot t$
$f(t=0.022) = 50.088 \pm 0.001$ Hz
ROCOF = 4.00 ± 0.06 Hz/s

## FIG. 5F

Sampling at 25600 Hz of a 50-Hz signal
Frequency calculation for 60-ms and 120-ms windows

60 ms
120 ms

## FIG. 6

Distorded sinusoidal signal and square waveform for ±0.50 levels

## FIG. 7A

Distorded sinusoidal signal and square waveform for a ±0.50 levels

## FIG. 7B

Distorded sinusoidal signal and square waveform for a ±0.50 levels

FIG. 7C

Distorded sinusoidal signal and square waveform for a ±0.50 levels

FIG. 8A

EP 4 478 060 B1

FIG. 8B

**EP 4 478 060 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 103575979 A
- CN 102095929 A
- CN 101871965 A
- CN 102879639 A
- CN 1815248 A
- CN 102116798 A
- CN 104360144 A
- CN 109669070 A
- CN 105259409 A
- GB 2528847 A
- JP H0943262 A
- GB 1338980 A
- US 7184937 B1
- US 4480200 A
- US 2017040900 A1
- CN 114217126 A
- US 11204377 B2
- CN 114217126 A1
- JP 2988039 B
- US 6417701 B1
- US 5019722 A

**Non-patent literature cited in the description**

- Applying Measurement Uncertainty To Digital Multimeter Calibration [PowerPoint slides. **SOMPPI, J.** Fluke's Calibration Business Unit. Fluke Corporation, 2011
- **MONTGOMERY, D. C.** ; **RUNGER, G. C.** Applied statistics and probability for engineers 5E binder ready version. John Wiley & Sons, 2010, 405-410